# EUROPEAN PATENT SPECIFICATION

(11) **EP 2 391 187 B1**
(45) Date of publication and mention of the grant of the patent: **24.04.2013**
(21) Application number: 10783089.5
(22) Date of filing: 11.05.2010
(51) Int. Cl.: H05B 33/22, H01L 51/50, H05B 33/10, H05B 33/12, H05B 33/26, H01L 27/32, H01L 51/52

(54) **ORGANIC EL DISPLAY PANEL AND METHOD FOR MANUFACTURING SAME**
ORGANISCHE EL-ANZEIGETAFEL UND VERFAHREN ZU IHRER HERSTELLUNG
PANNEAU D'AFFICHAGE ÉLECTROLUMINESCENT ORGANIQUE ET PROCÉDÉ DE FABRICATION ASSOCIÉ

(30) Priority: 04.06.2009 JP 2009135322
(43) Date of publication of application: 30.11.2011
(73) Proprietor: Panasonic Corporation, Kadoma-shi Osaka 571-8501 (JP)
(72) Inventor: Shuhei Nakatani, Osaka 540-6207 (JP); Masahiro Muro, Osaka 540 -6207 (JP)
(74) Representative: Grünecker, Kinkeldey, Stockmair & Schwanhäusser
(86) International application number: PCT/JP2010/003198
(87) International publication number: WO 2010/140301

(56) References cited:
- JP-A- 2002 318 556
- JP-A- 2003 059 660
- JP-A- 2007 080 603
- JP-A- 2007 115 563
- JP-A- 2007 310 156
- JP-A- 2009 054 608
- US-A1- 2005 179 377

## Description

### Technical Field

The technical field relates to an organic EL display panel and a method for manufacturing the same.

### Background Art

An organic EL display panel refers to a display panel which includes light-emitting devices (organic EL devices) exploiting electroluminescence (EL) of organic compounds. Specifically, the organic EL display panel has organic EL devices each including a pixel electrode, an organic light-emitting layer disposed over the pixel electrode, and a counter electrode disposed over the organic light-emitting layer. Organic EL materials used for the organic light-emitting layer can be broadly classified into two types: combinations of low-molecular weight compounds (combinations of host and dopant materials); and organic polymer compounds. Examples of organic polymer compounds include polyphenylenevinylene (abbreviated as "PPV") or its derivatives. An organic EL display panel that utilizes organic polymer compounds can be driven at relatively low voltage and consumes less power, lending itself to development of large display panels. Under this circumstance, extensive research activities are underway.

However, when a display panel that has organic EL devices is enlarged, regions occur in the panel to which an electrical current from wiring is not fully supplied, which causes brightness difference between the edge and central part of the panel. In particular, in an active-matrix organic EL display panel in which organic EL devices are driven by respective TFTs, the devices share one common counter electrode; therefore, for example, a pixel located at a panel center and a pixel located at a panel edge have different distances from the ground electrode. When the pixel-to-ground electrode distance varies depending on the pixel position, the wiring resistance also varies depending on the pixel position. Also, it becomes likely that the amount of the electric current that flows through the counter electrode becomes uneven. For this, organic EL devices, especially active-matrix organic EL display panels, have had the problem of significant brightness variations.

As a measure to overcome this problem, it is known to form highly conductive bus electrodes that are electrically connected to the counter electrode (see, e.g., Patent Literatures 1 to 7 listed below).

Document US 2005/0179377 describes an organic electroluminescent device that includes a substrate, a plurality of first electrodes, a partition structure having a plurality of openings located at positions corresponding to the first electrodes, organic functional layers each placed in the corresponding openings, a second electrode disposed over the partition structure and the organic functional layers, a sealing layer disposed over the second electrode, and a protective substrate, those components being disposed on or above the substrate. The organic electroluminescent device also incudes a stress relief structure including a plurality of island-shaped members arranged along at least one part of outer ends of the partition structure. Portions of the second electrode are connected to a cathode wire extending inside the edges of the substrate and outside an area containing the island-shaped members.

Fig.1 is a sectional view of the organic EL device disclosed by Patent Literature 1. As illustrated in Fig.1, the organic EL device disclosed by Patent Literature 1 includes pixel electrode 13 disposed on insulating substrate 1, organic layer 15 disposed over pixel electrode 13, counter electrode 17 disposed over organic layer 15, and bus electrode 19 disposed on insulating substrate 11. Bus electrode 19 is connected to counter electrode 17.

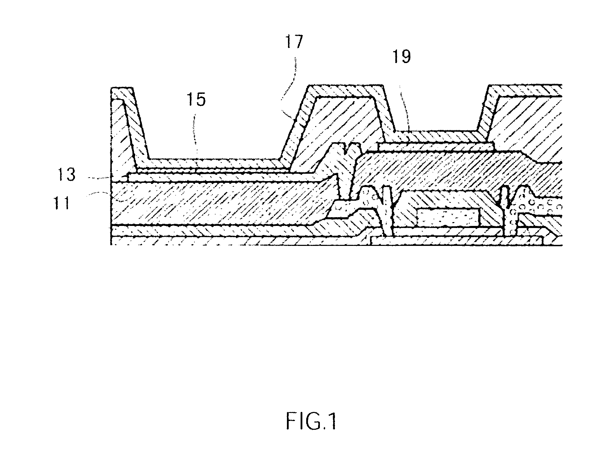

Since bus electrode 19 is electrically connected to counter electrode 17 in the organic EL device illustrated in Fig. 1, even when the resistance of counter electrode 17 is high, it is possible to make uniform the amount of current that flows through counter electrode 17 and thus to prevent brightness variations across the panel.

### Citation List

### Patent Literature

[PTL 1] Japanese Patent Application Laid-Open No.2004-111369
[PTL 2] Japanese Patent Application Laid-Open No.2006-113376
[PTL 3] Japanese Patent Application Laid-Open No.2007-103126
[PTL 4] Japanese Patent Application Laid-Open No.2005-031645
[PTL 5] U.S. Patent Application Publication No.2006/0082284
[PTL 6] U.S. Patent Application Publication No.2005/0051776
[PTL 7] U.S. Patent Application Publication No.2004/0108810

### Summary of Invention

### Technical Problem

However, in the case of an organic EL display panel such as that illustrated in Fig.1 in which a bus electrode is connected to a counter electrode, formation of an organic layer by coating method such as inkjet printing gives rise to a problem that the thickness of the organic layer becomes non-uniform. Uneven organic layer thickness not only results in brightness variations across the organic EL display panel, but also shortens the panel life.

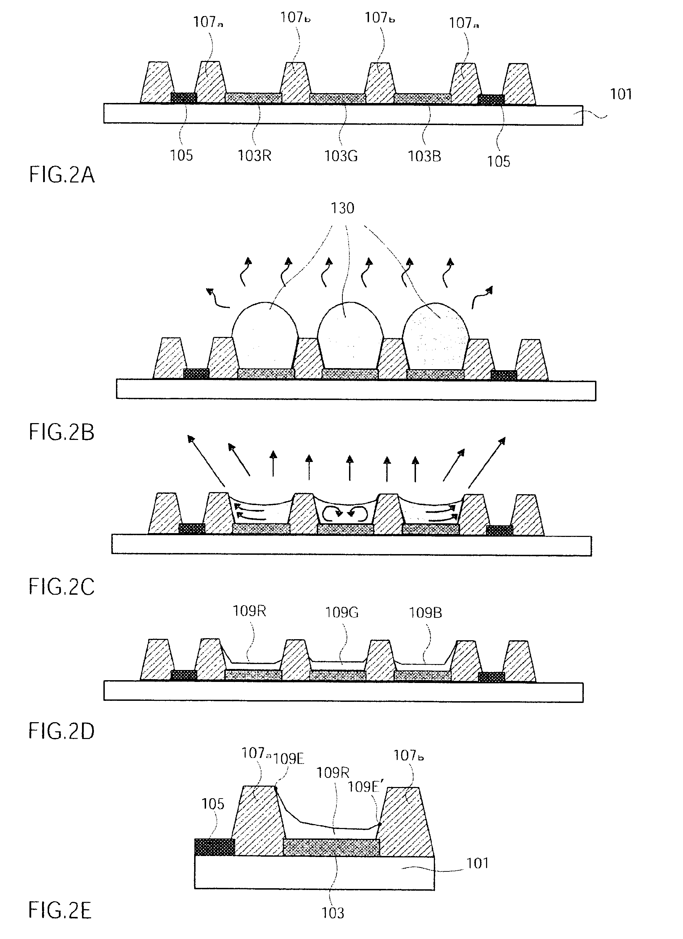

With reference to Figs.2A to 2D, the relationship between providing a bus electrode and the fact that the thickness of an organic layer formed by coating method becomes non-uniform will be described below.

Fig.2A is a partial enlarged view of a section of an organic EL display panel before an organic layer is formed. The organic EL display panel illustrated in Fig.2A includes pixel electrodes 103R, 103G and 103B, bus electrodes 105 and banks 107, which are disposed on substrate 101. Banks 107 includes bank 107a disposed between bus electrode 105 and pixel electrode 103 (hereinafter may referred to as "pixel-to-bus bank"), and bank 107b disposed between pixel electrodes (hereinafter may also referred to as "pixel-to-pixel bank).

An organic layer which emits red light (organic light-emitting layer) is disposed on pixel electrode 103R, an organic layer which emits green light is disposed on pixel electrode 103G, and an organic layer which emits blue light is disposed on pixel electrode 103B (see Fig.2D). Typically, bus electrodes 105 are so disposed as to sandwich a pixel consisting of red, green and blue sub-pixels.

Fig.2B illustrates a state where material solution 130 of organic layer has been applied over on pixel electrode 103 in regions defined by bank 107. Because material solution 130 of organic layer does not exist over bus electrode 105, the vapor concentration of the solvent of material solution 130 is low near pixel-to-bus bank 107a.

Fig.2C illustrates a state where material solution 130 of organic layer present in the region defined by bank 107 is drying up. Drying of the material solution of organic layer is facilitated near bus electrode 105 due to low vapor concentration of the solvent of the material solution. Since the applied material solution moves to a part where the rate of drying is higher, the material solution applied over pixel electrode 103R is drawn to the pixel-to-bus bank 107a. Similarly, material solution 130 applied over pixel electrode 103B is drawn to the pixel-to-bus bank 107a.

As a result, as illustrated in Fig.2D, organic layers 109R and 109B formed in the regions defined by pixel-to-bus bank 107a and pixel-to-pixel bank 107b exhibit a variation in edge height. Fig.2E is an enlarged view of organic layer 109R illustrated in Fig.2D. As illustrated in Fig.2E, edge 109E of organic layer 109R on the pixel-to-bus bank 107a side is higher than edge 109E' on the pixel-to-pixel bank 107b bank side.

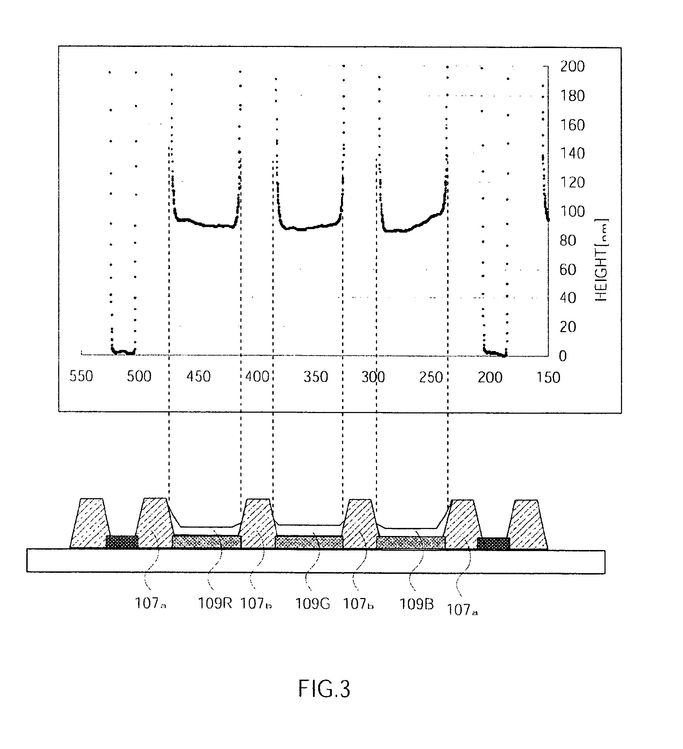

Variation in organic layer's edge height results in non-uniform thickness. Fig.3 shows thickness distributions of the organic layers of the organic EL display panel illustrated in Fig.2D. As seen from Fig.3, organic layers 109R and 109B formed in regions defined by pixel-to-bus bank 107a and pixel-to-pixel bank 107b become thick on the pixel-to-bus bank 107a side, and become thin on the pixel-to-pixel bank 107b side. With this bus electrode arrangement, the organic layer may exhibit a variation in edge height and thus non-uniform thickness.

It is therefore an object of the present invention to provide an organic EL display panel having uniform-thick organic layers even when bus electrodes are provided.

### Solution to the problem

This object is achieved by the present invention as claimed in the independent claims. Advantageous embodiments of the present invention are defined by the dependent claims.

The inventors have established that by adjusting the property of a bank disposed between a bus electrode and a pixel electrode and the property of a bank disposed between pixel electrodes, it is possible to level the edge height, and therefore the thickness, of an organic layer. Further, with additional studies, the inventors completed the present invention.

That is, a first illustrative example for understanding the present invention relates to an organic EL display panel given below.
(1) An organic EL display panel including:
   a substrate;
   two or more pixel electrodes disposed on the substrate;
   a bus electrode disposed on the substrate, the bus electrode disposed next to at least one of the pixel electrodes;
   an organic layer disposed over the pixel electrode;
   two or more banks disposed on the substrate, the banks defining a region in which the organic layer is disposed; and
   a counter electrode disposed over the organic layer, the counter electrode connected to the bus electrode,
   wherein the two or more banks include a bank disposed between the bus electrode and the pixel electrode, and a bank disposed between the pixel electrodes, and
   a lyophilicity of the bank disposed between the bus electrode and the pixel electrode is lower than a lyophilicity of the bank disposed between the pixel electrodes.

A second illustrative example for understanding the present invention relates to an organic EL display panel given below.
(2) An organic EL display panel including:
   a substrate;
   two or more pixel electrodes disposed on the substrate;
   a bus electrode disposed on the substrate, the bus electrode disposed next to at least one of the pixel electrodes;
   an organic layer disposed over the pixel electrode;
   two or more banks disposed on the substrate, the banks defining a region in which the organic layer is disposed; and
   a counter electrode disposed over the organic layer, the counter electrode connected to the bus electrode,
   wherein the two or more banks include a bank disposed between the bus electrode and the pixel electrode, and a bank disposed between the pixel electrodes, and
   a taper angle of the bank disposed between the bus electrode and the pixel electrode is smaller than a taper angle of the bank disposed between the pixel electrodes.

A third illustrative example for understanding the present invention relates to a manufacturing method of an organic EL display panel given below.
(3) A manufacturing method of an organic EL display panel, including:
   providing a substrate having thereon two or more pixel electrodes and a bus electrode disposed next to at least one of the pixel electrodes;
   forming a photosensitive resin film on the substrate;
   exposing and developing the photosensitive resin film to pattern two or more banks, the two or more banks including a bank disposed between the bus electrode and the pixel electrode, and a bank disposed between the pixel electrodes;
   baking the two or more banks for securing the two or more banks to the substrate;
   irradiating only the bank disposed between the pixel electrodes with active rays; and
   applying an ink containing a material of organic layer in a region which is positioned over the pixel electrode and defined by the two or more banks, to form an organic layer.

A fourth illustrative example of the present invention relates to a manufacturing method of an organic EL display panel given below.
(4) A manufacturing method of an organic EL display panel, including:
   providing a substrate having thereon two or more pixel electrodes and a bus electrode disposed next to at least one of the pixel electrodes;
   forming a negative photosensitive resin film on the substrate;
   exposing and developing the photosensitive resin film to pattern two or more banks, the two or more banks including a bank disposed between the bus electrode and the pixel electrode, and a bank disposed between the pixel electrodes;
   re-exposing only the bank disposed between the pixel electrodes;
   baking the two or more banks for securing the two or more banks to the substrate; and
   applying an ink containing a material of organic layer in a region which is positioned over the pixel electrode and defined by the two or more banks, to form an organic layer.

### Advantageous Effects of Invention

According to the present invention, even when bus electrodes are provided, it is possible to level the edge height, and therefore thickness, of an organic layer. Thus, according to the present invention, it is possible to provide an organic EL display panel which exhibits small organic layer thickness variation and offers excellent luminescence characteristics.

### Brief Description of Drawings

Fig.1 is a sectional view of an organic EL device contained in a conventional organic EL display panel;
Figs.2A to 2E illustrate how organic layers are formed in the case where bus electrodes are disposed so as to sandwich pixel electrodes;
Fig.3 is a graph of thickness distributions of organic layer;
Fig.4 is a graph of the relationship between UV irradiation time and the contact angle of anisole at the upper bank surface;
Figs.5A to 5C are schematic illustrations depicting the behavior of material solution in a drying process;
Figs.6A to 6E are schematic illustrations depicting the behavior of material solution in a drying process;
Fig.7 is a sectional view of an organic EL display panel of Embodiment 1;
Figs.8A to 8D illustrate a manufacturing method of the organic EL display panel of Embodiment 1;
Figs.9A to 9C illustrate a manufacturing method of the organic EL display panel of Embodiment 1;
Fig.10 is a sectional view of an organic EL display panel of Embodiment 2; and
Figs. 11A to 11E illustrate a manufacturing method of the organic EL display panel of Embodiment 2.

### Description of Embodiments

### 1. Organic EL Display Panel of Present Invention

An organic EL display panel of the present invention includes a matrix of organic EL devices disposed on a substrate. Each organic EL device includes a pixel electrode, an organic layer disposed over the pixel electrode; and a counter electrode disposed over the organic layer. In the present invention the organic layer is formed by coating method.
More specifically, an organic EL display panel of the present invention includes 1) a substrate; 2) a bus electrode, 3) two or more pixel electrodes; 4) two or more banks, 5) two or more organic layers; and 6) a counter electrode. As will be described later, an organic EL display panel of the present invention is characterized in the bank property.

The present invention aims at suppressing thickness variation in the organic layer formed near a bus electrode that is connected to the counter electrode. Thus, the present invention is particularly effective for active-matrix organic EL display panels, which require bus electrodes. Hereinafter, each component of the organic EL display panel of the present invention will be described.

### 1) Substrate

The material of a substrate of an organic EL display panel of the present invention varies depending on whether the organic display panel is of the top mission type or bottom emission type. For example, in the case of bottom emission type, the substrate needs to be transparent. Examples of materials for such a transparent substrate include glass and transparent resin. In the case of top emission type, on the other hand, the substrate needs not to be transparent. In this case, it is only necessary that the substrate be made of insulating material.

The substrate may include thin-film transistors for driving organic EL devices (driving TFTs). The source electrode or drain electrode of each TFT is connected to a pixel electrode (later described). The organic EL device may be disposed on the same plane as the source electrode or drain electrode of the TFT device. The organic EL device may, of course, be disposed over the TFT device.

### 2) Pixel electrode

A pixel electrode is a conductive member disposed on the substrate. An organic EL display panel of the present invention includes a matrix of organic EL devices disposed on a substrate. The pixel electrode generally serves as anode, but may also serve as cathode.
In bottom emission type organic EL display panels, pixel electrodes need to be transparent. Examples of materials of pixel electrode include indium tin oxide (ITO), indium zinc oxide (IZO), and zinc oxide (ZnO).
Top emission type organic EL display panels require light reflectivity in pixel electrodes. Examples of materials of the pixel electrode for top-emission type include silver-containing alloys, more specifically silver-palladium-copper alloys (also referred to as "APC") and silver-ruthenium-gold alloys (also referred to as "ARA"); molybdenum/chrome (MoCr) alloys; nickel/chrome (NiCr) alloys; and aluminum alloys such as aluminum-neodymium (A1-Nd) alloys. Moreover, reflective pixel electrodes may have an ITO film or indium zinc oxide (IZO) film attached on their surface. The pixel electrode thickness is generally 100 to 500 nm and may be about 150 nm.

A hole injection layer may be disposed over the pixel electrode. The hole injection layer helps holes to be injected from the pixel electrode to the organic layer (later described). Thus, the hole injection layer is disposed between the pixel electrode and organic layer.

Examples of the material of the hole injection layer include poly(3,4-ethylenedioxythiophene) doped with polyethylene sulfonate (referred to as "PEDOT-PSS") and transition metal oxides, with transition metal oxides being preferable. A hole injection layer made of PEDOT is formed by coating method; therefore, the thickness is less likely to be uniform. Moreover, because PEDTO is conductive, a short circuit is highly likely to occur within the organic EL device. A hole injection layer made of transition metal oxide is, on the other hand, is formed by sputtering; therefore, the thickness becomes uniform.

Examples of transition metals include tungsten, molybdenum, titanium, vanadium, ruthenium, manganese, chrome, nickel, iridium, and combinations thereof. Preferred hole injection material is tungsten oxide (WOx) or molybdenum oxide (MoOx). The hole injection layer thickness is generally 10 to 100 nm and may be about 30 nm. The hole injection layer may be omitted as long as holes can be efficiently injected into the organic layer from the pixel electrode.

### 3) Bus electrode

A bus electrode is a conductive member for correcting variations in wiring resistance. With a bus electrode, a uniform voltage can be applied to pixels across the panel. The bus electrode is disposed on a substrate. The bus electrode is electrically connected to a counter electrode (later described). The bus electrode is disposed next to at least one pixel electrode. The bus electrode and pixel electrode may be electrically insulated by a bank (later described). The material of the bus electrode may be identical to or different from the material of the pixel electrode.

### 4) Bank

A bank is a partition wall for defining a region in which an organic layer (later described) is to be formed. Banks are disposed on a substrate. The banks includes a bank disposed between a bus electrode and a pixel electrode (hereinafter may referred to as "pixel-to-bus bank"), and a bank disposed between pixel electrodes (hereinafter may also referred to as "pixel-to-pixel bank). The present invention is **characterized in that** the pixel-to-bus bank and pixel-to-pixel bank have different properties. Properties of the pixel-to-bus bank and pixel-to-pixel bank will be described later.

The bank height as measured from the substrate surface is preferably 0.1 to 3 µm, most preferably 0.8 to 1.2 µm. When the bank height is more than 3 µm, there is concern that a single counter electrode shared by organic EL devices (later described) is separated by the banks. When the bank height is less than 0.1µm, there is concern of leakage of ink applied in regions defined by the bank.

Also, the bank preferably has a forward tapered shape. As used herein, the term "forward tapered shape" means that the side surface of bank is inclined in such a way that the bank bottom area is larger than the bank upper area. When bank shape is tapered in this way, taper angle is preferably 20° to 80°, most preferably 30° to 50°. When taper angle exceeds 80°, there is concern that a single counter electrode shared by organic EL devices (later described) is separated by the banks.

The bank material is not particularly limited as long as it is resin; it is preferably fluorine resin. Examples of fluorine compounds contained in fluorine resins include vinylidene fluoride, vinyl fluoride, ethylene trifluoride, and fluorinated resins such as copolymers thereof. Examples of resins contained in fluorine resins include phenol-novolac resins, polyvinylphenol resins, acrylic resins, methacrylic resins, and combinations thereof.

Specific examples of fluorine resins include LUMIFRON" (Asahi Glass Co., Ltd.), a copolymer of fluorine polymer (fluoroethylene) disclosed by JP-A No.2002-543469 and vinylether.

The bank in the present invention is characterized by having low lyophilicity at the bank upper surface. Herein "bank upper surface" means a bank surface including the bank top. By lowering lyophilicity at the bank upper surface, it is possible to ensure the bank's inherent function of defining a region to which a material solution of organic layer formed by coating method is to be applied. Water contact angle at the bank upper surface is 80° or more, more preferably 90° or more, and anisole contact angle at the bank upper surface is preferably 30° to 70°. Contact angles of water and anisole may be measured using LCD Glass Cleanness & Treatment Analyzer (Kyowa Interface Science Co., Ltd.).

The bank preferably has higher lyophilicity at the wall surface than at the bank upper surface. Herein "bank wall surface" means a bank surface including a surface that contacts an organic layer (later described). By increasing the lyophilicity of bank wall surface, a material solution of organic layer becomes compatible with the wall surface, whereby the solution can be uniformly spread over the region defined by the bank. Anisole contact angle at the bank wall surface is preferably 3° to 30°.

Banks with low lyophilicity at the upper surface and high lyophilicity at the wall surface can be prepared by baking treatment of a fluorine resin film which has been patterned into desired shape.

Table 1 shows relationships between thickness (height) and surface lyophilicity of a baked fluorine resin film. Surface lyophilicity of a fluorine resin film is expressed in terms of water contact angle and anisole contact angle. Larger water contact angle or anisole contact angle means lower lyophilicity. Contact angles of water and anisole were measured using LCD Glass Cleanness & Treatment Analyzer (Kyowa Interface Science Co., Ltd.).

Table 1 also shows relationships between thickness (height) and surface fluorine concentration of a baked fluorine resin film. Fluorine atom concentration was measured with PHI Quantera SXM (ULVAC-PHI, Inc.), an X-ray photoelectron spectroscopy analyzer.

**Table 1**

| Thickness (µm) | Water contact angle | Anisole contact angle | Fluorine conc. (atom%) |
|---|---|---|---|
| 1 | 81.2° | 45.5° | 7.5 |
| 0.9 | 78.9° | 43.0° | 6.9 |
| 0.8 | 76.5° | 40.6° | 6.3 |
| 0.7 | 74.1° | 38.2° | 5.6 |
| 0.6 | 71.7° | 35.7° | 5.0 |
| 0.5 | 69.4° | 33.3° | 4.3 |
| 0.4 | 67.0° | 30.8° | 3.7 |
| 0.3 | 64.6° | 28.4° | 3.0 |
| 0.2 | 62.2° | 25.9° | 2.4 |
| 0.1 | 59.9° | 23.5° | 1.7 |

As shown in Table 1, the thicker (higher) a fluorine resin film, the higher the fluorine concentration at its surface. Since fluorine components offer lyophobic property, contact angles of water and anisole increase (lyophilicity decreases) with increasing fluorine concentration.

Thus, a bank formed of fluorine resin has least lyophilicity at the upper surface, and higher lyophilicity at a lower part of the wall surface.

To adjust bank lyophilicity, the bank may be subjected to plasma treatment using fluorine gas. When adjusting bank lyophilicity by plasma treatment using fluorine gas, the bank material is preferably polyimide or acrylic resin. Polyimides are particularly preferable as a bank material for their low water absorbability.

### Properties of Pixel-to-Bus Bank and Pixel-to-Pixel Bank

As described above the present invention is **characterized in that** a pixel-to-bus bank and a pixel-to-pixel bank have different properties. Herein, "property" of bank means surface lyophilicity or taper angle of bank. Specifically, the pixel-to-bus bank and pixel-to-pixel bank may be different in terms of either of lyophilicity or taper angle, or both. Hereinafter, properties of the pixel-to-bus bank and pixel-to-pixel bank will be described in respect of two cases: (i) a case where the banks differ in lyophilicity; and (ii) a case where the banks differ in taper angle.

### i) Case where the pixel-to-bus bank and pixel-to-pixel bank differ in lyophilicity

In this case, the pixel-to-bus bank preferably has lower surface lyophilicity than the pixel-to-pixel bank. More specifically, anisole contact angle at the upper surface of the pixel-to-bus bank is preferably 40° to 55°, whereas anisole contact angle at the upper surface of the pixel-to-pixel bank is preferably 30° to less than 40°. Further, the pixel-to-bus bank preferably has lower lyophilicity at the wall surface than the pixel-to-pixel bank. By making the lyophilicity of the pixel-to-bus bank lower than that of the pixel-to-pixel bank, it is possible to level the edge height of an organic layer formed in a region defined by the pixel-to-bus bank and pixel-to-pixel bank, thus making uniform organic layer thickness.

Making the lyophilicity of the pixel-to-bus bank lower than the lyophilicity of the pixel-to-pixel bank may be accomplished for instance by irradiating only the pixel-to-pixel bank with active rays, so that the pixel-to-pixel bank has increased lyophilicity.

Alternatively, since the degree of lyophilicity of a bank made of fluorine resin is dependent on height as described above, the lyophilicity of the pixel-to-bus bank may be lowered by making it higher than the pixel-to-pixel bank.

### ii) Case where the pixel-to-bus bank and pixel-to-pixel bank differ in taper angle

In this case, the taper angle of the pixel-to-bus bank on the pixel electrode side (hereinafter may simply be referred to as "taper angle of pixel-to-bus bank") is preferably smaller than the taper of the pixel-to-pixel bank. More specifically, the taper angle of the pixel-to-bus bank is preferably 20° to 30°, and the taper angle of the pixel-to-pixel bank is preferably greater than 30° to 60°. By making the taper angle of the pixel-to-bus bank smaller than the taper angle of the pixel-to-pixel bank, it is possible to level the edge height of an organic layer formed in a region defined by the pixel-to-bus bank and pixel-to-pixel bank, thus making uniform the organic layer thickness (see Embodiment 2).

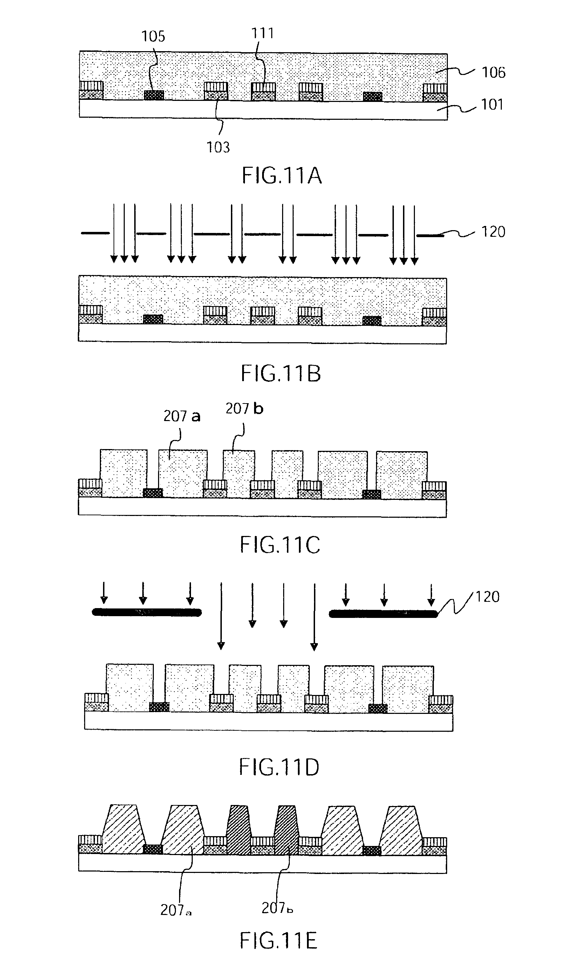

Making the taper angle of the pixel-to-bus bank smaller than the taper angle of the pixel-to-pixel bank may be accomplished for instance by re-exposing the patterned pixel-to-pixel bank, as will be described later (see Figs.11A to 11E).

### 5) Organic layer

An organic layer contains at least an organic light-emitting layer and is disposed over a pixel electrode. The organic layer is formed by applying a material solution of organic layer in a region defined by the bank. By applying an organic material solution (ink obtained by dissolving organic material into an organic solvent such as anisole or cyclohexylbenzene) in the region by coating method such as inkjet printing, an organic layer can be readily formed without damaging other members.

The conventional organic EL display panel having bus electrodes has a problem that the edge height of an organic layer formed in a region defined by the pixel-to-bus bank and pixel-to-pixel bank becomes non-uniform (see Fig.2E). With the present invention, by adjusting the properties of the pixel-to-bus bank and pixel-to-pixel bank as described above, it is possible to level the edge height of the organic layer formed in the region defined by the pixel-to-bus bank and pixel-to-pixel bank, making uniform organic layer thickness. Herein, "edge" of an organic layer" refers to an edge of a surface of an organic layer on the counter electrode side.

Organic EL material to be contained in the organic light-emitting layer may be either of polymer or low molecular weight as long as the organic light-emitting layer can be prepared by coating method.

Low-molecular weight organic EL material includes combinations of dopant material and host material. Examples of dopant material include BCzVBi (4,7-diphenyl-1,10-phenanthroline), Coumarin, rubrene, and DCJTB
([2-tert-butyl-6-[2-(2,3,6,7-tetrahydro-1,1,7,7-tetramethyl-1H,5H-benzo [ij]quinolizine-9-yl) vinyl]-4H-pyrane-4-ylidene] malononitrile). Examples of host material include DPVBi (4,4'-bis(2,2-diphenylethenyl) biphenyl), and Alq3 (tris(8-quinolinolato) aluminium).

Examples of polymeric organic EL material include polyphenylenevinylene and its derivatives, polyacetylene and its derivatives, polyphenylene and its derivatives, poly para phenylene ethylene and its derivatives, poly(3-hexylthiophene) (P3HT) and its derivatives, and polyfluorene (PF) and its derivatives. Polymeric organic EL material is preferable because by using polymeric organic EL material, the organic light-emitting layer can be readily formed by coating method.

Examples of low-molecular weight organic EL material include tris(8-quinolinolate) aluminum.

The organic EL material is appropriately selected so that sub-pixels produce desired color - red (R), green (G), or blue (B). For example, a green sub-pixel is disposed next to a red sub-pixel; a blue pixel is disposed next to the green pixel; a red sub-pixel is disposed next to the blue sub-pixel; and so forth. The thickness of the organic light-emitting layer is preferably about 50 to 150 nm (e.g., 60 nm).

The organic layer may further include a hole transport layer (interlayer), an electron transport layer and the like. The hole transport layer is made of polyaniline-based material or the like and has such functions as preventing the entry of electrons into the hole injection layer or pixel electrode and efficiently transporting holes to the organic light-emitting layer. Thus, the hole transport layer is disposed between the organic light-emitting layer and either the pixel electrode or the hole injection layer. The hole transport layer thickness is generally 5 to 100 nm, preferably 10 to 50 nm (e.g., 20 nm). The hole transport layer may be omitted as long as holes can be efficiently injected into the organic light-emitting layer.

### 6) Counter electrode

A counter electrode is a conductive member disposed over the organic layer. The counter electrode generally functions as cathode. The material of the counter electrode varies depending on whether the organic display panel is of the bottom mission type or top emission type. In the case of top emission type, the counter electrode needs to be transparent. Thus, examples of materials of the counter electrode include indium tin oxide (ITO) and indium zinc oxide (IZO). In the case of top emission type, an organic buffer layer may be disposed between the organic light-emitting layer and counter electrode.

Meanwhile, in the case of bottom emission type, the counter electrode needs not to be transparent. Thus, materials thereof can be selected arbitrarily; examples include barium (Ba), barium oxide (BaO), and aluminum (Al).

The counter electrode is generally formed by sputtering. All of the organic EL devices contained in the organic EL display panel may share a single counter electrode.

A sealing film may be disposed over the counter electrode. The sealing film protects the organic layer and pixel electrode against water, heat, and impact. Examples of materials of the sealing film include silicon nitride and silicon oxynitride. A preferable sealing film thickness is 20 to 500 nm.

When applying a voltage between the pixel electrode and counter electrode in an organic EL display panel configured as described above, holes and electrodes are injected into the organic layer from the pixel electrode and counter electrode, respectively. The holes and electrons thus injected are recombined in the organic layer, generating excitons, which cause the organic layer to emit light.

### 2. Manufacturing Method of Organic EL Display Panel of Present Invention

An organic EL display panel of the present invention may be manufactured by any desired method as long as the effects of the present invention are not impaired.

One example of a preferred manufacturing method includes:
1) a first step of providing a substrate having thereon two or more pixel electrodes and a bus electrode;
2) a second step of forming two or more banks on the substrate;
3) a third step of forming an organic layer in a region defined by the banks; and
4) a fourth step of forming a counter electrode over the organic layer.
Each step will be described below.

1) In the first step, a substrate is provided on which two or more pixel electrodes and a bus electrode are disposed. The pixel electrodes and bus electrode may be formed by forming a conductive thin film over the substrate by sputtering or the like and patterning the conductive film by etching. In the case where the bus electrode and pixel electrode are made of the same material, they may be formed at the same time.

2) In the second step, two or more banks are formed on the substrate. As described above, the banks include a pixel-to-bus bank and a pixel-to-pixel bank. The step of forming banks on the substrate further includes: i) a step of forming a photosensitive resin film on the substrate; ii) a step of exposing and developing the photosensitive resin film to pattern banks; and iii) a step of baking the patterned banks so as to secure the banks to the substrate.

i) In step (i), a photosensitive resin film is formed on the substrate. Formation of a photosensitive resin film may be accomplished by applying a photosensitive resin composition over the substrate by spin coating, die coating, slit coating or the like and baking the formed film. Baking condition is not particularly limited; the formed film may be allowed to stand for 2 to 3 minutes at 80 to 100°C (e.g., 80°C).

ii) In step (ii), the photosensitive resin film formed on the substrate is exposed and developed to pattern banks. By patterning banks, the pixel electrodes and bus electrode are exposed. Exposure condition is not particularly limited; exposure dose is set to 100 to 300 mJ/cm² (e.g., 200 mJ/cm²), and i line (main peak =365 nm) may be employed as exposure light. Development of the photosensitive resin film may be accomplished by immersing the exposed photosensitive resin film in, for example, 0.2% tetramethylammonium hydroxide (TMAH) solution for 60 seconds and rinsing it with pure water for 60 seconds.

iii) In step (iii), the patterned banks are baked, securing the banks to the substrate. Baking condition is not particularly limited; for example, baking temperature is set to around 200°C or higher (e.g., 220°C), and baking time is about 1 hour. Baking of the patterned banks rids them of internal solvent and water, thus improving their adhesion to the substrate and securing them to the substrate. Although the banks immediately after patterned have a taper angle of about 90° and thus do not have a forward tapered shape (see Fig.11C), the elastic modulus drops due to heat during the baking process, whereby the banks spread toward the bottom in a forward tapered shape (see Fig.11E).

As described above, the present invention is **characterized in that** the lyophilicity of the pixel-to-bus bank is lower than the lyophilicity of the pixel-to-pixel bank, or that the taper angle of the pixel-to-bus bank is smaller than the taper angle of the pixel-to-pixel bank. Hereinafter, A) a means for making the lyophilicity of the pixel-to-bus bank lower than the lyophilicity of the pixel-to-pixel bank, and B) a means for making the taper angle of the pixel-to-bus bank smaller than the taper angle of the pixel-to-pixel bank will be described.

### A) Means for making the lyophilicity of the pixel-to-bus bank lower than the lyophilicity of the pixel-to-pixel bank (see Embodiment 1)

Making the lyophilicity of the pixel-to-bus bank lower than the lyophilicity of the pixel-to-pixel bank may be accomplished for instance by, after formation of banks on the substrate, irradiating only the pixel-to-pixel bank with active rays. Radiation of active rays exclusively on the pixel-to-pixel bank may be accomplished by the use of a mask. Examples of active rays include ultraviolet rays, electron rays, radioactive rays, and plasma. For good handleabillity, ultraviolet rays are preferable. Examples of ultraviolet rays include excimer UV with 172 nm wavelength. Irradiation time is generally 2 to 10 seconds.

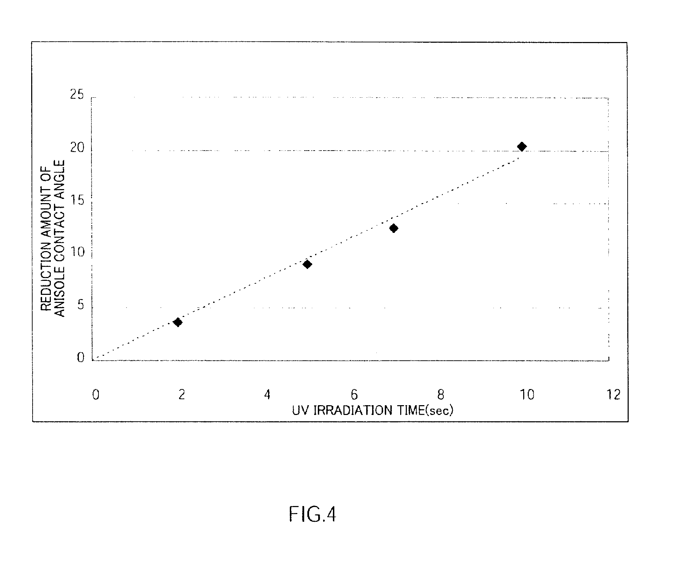

Fig.4 is a graph depicting the relationship between UV irradiation time and bank lyophilicity (reduction in anisole contact angle), as measured by irradiating banks made of fluorine resin with UV rays (wavelength = 172 nm).
As shown in Fig.4, anisole contact angle decreases (i.e., lyophilicity increases) with increasing UV irradiation time. More specifically, 5-second UV irradiation reduces the anisole contact angle at the bank surface by approximately 10°. By irradiating the pixel-to-pixel bank with UV rays in this way, it is possible to increase the lyophilicity of the pixel-to-pixel bank. It is thus possible to make the lyophilicity of the pixel-to-pixel bank lower than the lyophilicity of the pixel-to-bus bank.

Moreover, UV irradiation provides a secondary effect of removing bank residues remained on the pixel electrode. By removing bank residues on the pixel electrode in this way, it is possible to improve luminous characteristics of the organic EL display panel.

Since the degree of lyophilicity of a bank made of fluorine resin is dependent on height as described above, the lyophilicity of the pixel-to-bus bank may also be lowered by employing fluorine resin as bank material and making the pixel-to-bus bank higher than the pixel-to-pixel bank. Making the pixel-to-bus bank higher than the pixel-to-pixel bank may be accomplished by exposing the photosensitive resin film in step (ii) through a halftone mask with different degrees of light transmittance.

### B) Means for making the taper angle of the pixel-to-bus bank smaller than the taper angle of the pixel-to-pixel bank (see Embodiment 2)

The means for making the taper angle of the pixel-to-bus bank smaller than the taper angle of the pixel-to-pixel bank is not particularly limited; for example, it can be accomplished by employing a negative photosensitive resin as a material of the bank and, between step (ii) and step (iii), re-exposing only the pixel-to-pixel bank. Re-exposure of the pixel-to-pixel bank increases the bank's glass transition temperature and elastic modulus. The mechanism by which re-exposure increases bank's glass transition temperature and elastic modulus is not particularly limited. One mechanism is that portions of resin material which were not fully polymerized and cured by the exposure process in step (ii) are polymerized and cured by re-exposure. Exposure dose upon re-exposure is not particularly limited, and is 200 to 400 mJ/cm² for example, preferably about 300 mJ/cm².

Elevation in glass transition temperature and elastic modulus prevents reduction in the elastic modulus of the pixel-to-pixel bank due to heat during the baking process, whereby the pixel-to-pixel bank spreads toward the bottom to a lesser extent and thus has a large taper angle. On the other hand, since the glass transition temperature and elastic modulus of the pixel-to-bus bank, which is not re-exposed, remain low, the elastic modulus drops due to heat during the baking process. Thus, the pixel-to-bus bank spreads toward the bottom and thus has a small taper angle (see Fig.11E). In this way, it is possible to make the taper angle of the pixel-to-bus bank smaller than the taper angle of the pixel-to-pixel bank.

3) In the third step, an organic layer is formed in a region defined by the banks. The organic layer is formed by drying a material solution of organic layer applied in the region defined by the banks. The organic layer may be secured by a subsequent baking process.

The material solution of organic layer to be applied contains an organic layer material and a solvent. Examples of solvents include aromatic solvents such as anisole and cyclohexylbenzene. Examples of coating methods of the material solution include inkjet printing, dispensing, nozzle coating, spin coating, intaglio printing, and relief printing. A preferred coating method is inkjet printing.

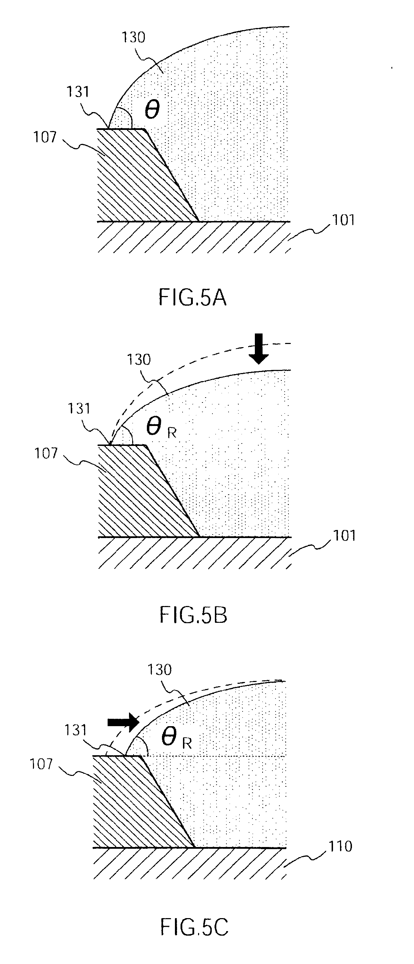

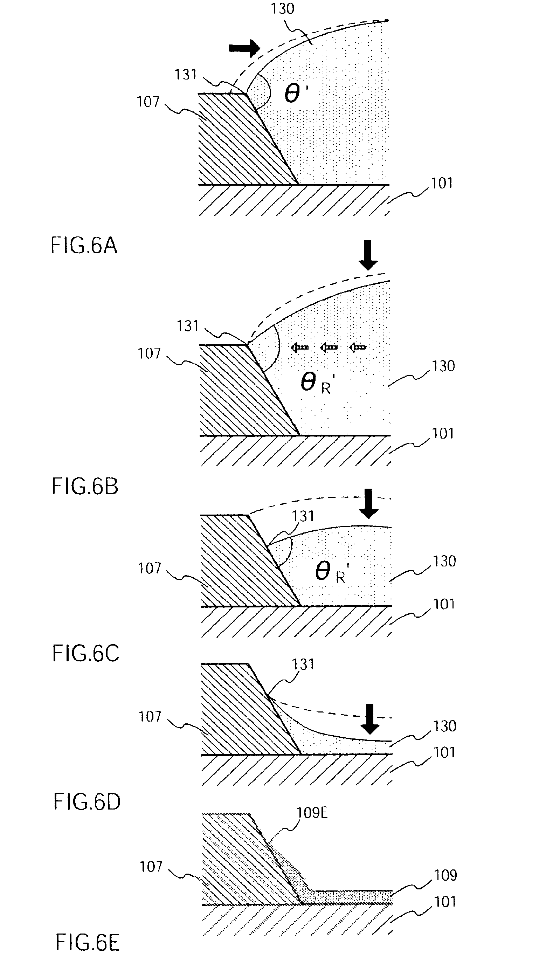

The following describes how a material solution of organic solution applied in a region defined by banks dries. Figs.5A to 5C and 6A to 6E are schematic illustrations depicting the typical behavior of the material solution in a drying process.

Fig.5A is a schematic illustration showing a state of a material solution of organic layer immediately after it has been applied in a region defined by banks. As illustrated in Fig.5A, material solution 130 is applied in such a way as to reach the upper surface of bank 107 formed on substrate 101 and not to flow in adjacent sub-pixels partitioned by the bank. Immediately after the coating process, material solution 130 retains a contact angle of 0 with respect to the bank upper surface by the balance of surface tension forces at liquid droplet edge 131.

Once material solution 130 starts to dry up, evaporation of solvent causes contact angle θ to decrease to receding contact angle θ_{R}, with the position of liquid droplet edge 131 fixed so long as the balance of surface tension forces is maintained, as illustrated in Fig.5B. This type of drying mode is called "constant contact radius (CCR) mode" as the radius of a liquid droplet is kept constant.

It should be noted that receding contact angle θ_{R} varies depending on the property (e.g., viscosity) of the material solution and physical properties (e.g., surface free energy) of bank surface. For example, receding contact angle θ_{R} increases when the lyophilicity of bank surface decreases.

Once the contact angle of material solution 130 at liquid droplet edge 131 has decreased to receding contact angle θ_{R}, the balance of surface tension forces at liquid droplet edge 131 is disrupted, resulting in the generation of a force that draws material solution 130 toward the inside of the coating region. As a consequence, as illustrated in Fig.5C, liquid droplet edge 131 moves toward the inside of the coating region due to evaporation of solvent, with receding contact angle θ_{R} kept constant, thus reducing the radius of the liquid droplet. This type of drying mode is called "constant contact angle (CCA) mode" as the contact angle with respect to the substrate is kept constant. Reduction of liquid droplet radius continues until liquid droplet edge 131 reaches the corner of the bank (i.e., boundary between the upper surface and wall surface of the bank).

Once liquid droplet edge 131 has reached the corner of bank 107, the reference surface on which measurement of contact angle is based changes from bank upper surface to bank wall surface, as illustrated in Fig.6A; therefore, contact angle increases to 0'. Contact angle thus becomes larger than receding contact angle and thereby the surface tension forces at liquid droplet edge 131 are again balanced. As a result, as illustrated in Fig.6B, contact angle θ' decreases to receding contact angle θ_{R}' due to evaporation of solvent, with liquid droplet edge 131 fixed at the corner of bank 170.

Once the contact angle has decreased to receding contact angle θ_{R}', as illustrated in Fig.6C, evaporation of solvent causes liquid droplet edge 131 to move down the wall surface with contact angle θ_{R}' kept constant, and thereby the volume of the liquid droplet decreases (CCA mode).

When the concentration of the solute in the vicinity of liquid droplet edge 131 has reached a critical concentration due to drying, as illustrated in Fig.6D, material solution 130 is gelled, and liquid droplet edge 131 is fixed to the wall surface of bank 107. The positioning of a liquid droplet edge in this manner is called "pinning". In particular, pinning that occurs due to elevation in the concentration (viscosity) of a material solution is called "self-pinning." After self-pinning has occurred, drying continues in a state where liquid droplet edge 131 is fixed to the wall surface as illustrated in Fig.6E, resulting in the formation of organic layer 109.

In this way, in regions defined by banks, drying of solution proceeds while alternately repeating CCR mode and CCA mode.

When the bank lyophilicity is lowered, receding contact angle become large. For this reason, once the solvent has evaporated, the contact angle at liquid droplet edge 131 immediately reaches receding contact angle θ_{R}', thus prolonging the CCA mode drying period where liquid droplet edge 131 moves down to reduce the liquid volume. Prolonged drying period in CCA mode allows liquid droplet edge 131 to move down to lower positions of the wall surface of bank 107 before the solute concentration of the liquid droplet reaches a critical concentration.
As a result, the position at which liquid droplet edge 131 is fixed to the wall surface of bank 107 becomes low (i.e., the edge height of the organic layer lowers). By reducing the bank lyophilicity in this way, it is possible to lower the edge height of the organic layer on the bank wall surface having reduced lyophilicity.

When the taper angle of bank is lowered, a droplet of material solution 130 has a small contact angle on the bank wall surface. For this reason, once the solvent has evaporated, the contact angle immediately reaches receding contact angle θ_{R}', thus prolonging the CCA mode drying period where liquid droplet edge 131 moves down to reduce the liquid volume. Prolonged drying period in CCA mode allows liquid droplet edge 131 to move down to lower positions of the wall surface of bank 107 before the solute concentration of the liquid droplet reaches a critical concentration.
As a result, the position at which liquid droplet edge 131 is fixed to the wall surface of bank 107 becomes low (i.e., the edge height of the organic layer lowers). By reducing the bank taper angle in this way, it is possible to lower the edge height of the organic layer on the bank wall surface with small taper angle.

Conventional organic EL display panels have had a problem that the edge height of an organic layer formed in a region defined by a pixel-to-bus bank and a pixel-to-pixel bank becomes large on the pixel-to-bus bank side. The present invention is characterized by reducing the lyophilicity or taper angle of the pixel-to-bus bank in order to lower the edge height of an organic layer on the pixel-to-bus bank side and thus to form a uniform thick organic layer.

4) In the fourth step, a counter electrode is formed over the organic layer. The counter electrode is preferably formed by sputtering or the like.

According to the present invention, by adjusting bank's property, it is possible to level the edge height of an organic layer and thus to level organic layer thickness. Thus, according to the present invention, it is possible to provide an organic EL display panel that offer excellent luminous characteristics.

Hereinafter, embodiments of the present invention will be described with reference to the drawings.

### (Embodiment 1)

Embodiment 1 describes an embodiment in which a pixel-to-bus bank has low lyophilicity. Also, the organic EL display panel of Embodiment 1 is of the top emission type.

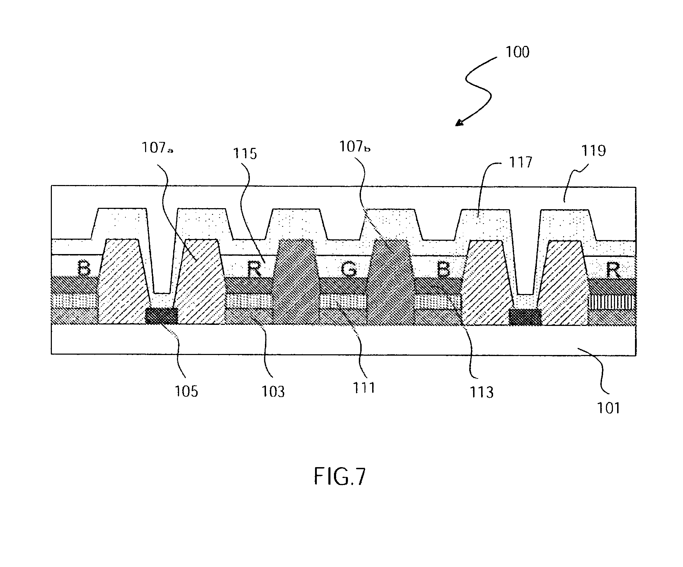

Fig.7 is a partial enlarged view of a section of organic EL display panel 100 of Embodiment 1. As illustrated in Fig. 7, organic EL display panel 100 includes substrate 101, reflective pixel electrode 103, bus electrode 105, hole injection layer 111, hole transport layer 113, organic light-emitting layers 115 of three different colors (red, green and blue), bank 107, counter electrode 117, and sealing film 119.

Substrate 101 is a glass plate, for example. Reflective pixel electrode 103 is an APC alloy layer with 100 to 200 nm thickness, for example. Bus electrode 105 is made of similar material to reflective pixel electrode 103.

Hole injection layer 111 is a layer made of tungsten oxide (WOx) with a thickness of 20 to 50 nm, and is disposed over reflective pixel electrode 103.

Hole transport layer 113 is a layer made of polyaniline with a thickness of 20 to 150 nm, and is disposed over hole injection layer 111.

Organic light-emitting layer 115 is a layer made of polyfluorene derivative with a thickness of 50 to 150 nm, and is disposed over hole transport layer 113.

Banks 107 are disposed on substrate 101 and define a region of hole transport layer 113 and organic light-emitting layer 115. Banks 107 are also disposed so as to cover a part of hole injection layer 111 and a part of bus electrode 105.

Banks 107 include pixel-to-bus bank 107a disposed between bus electrode 105 and pixel electrode 103, and pixel-to-pixel bank 107b disposed between pixel electrodes 103. In this embodiment, pixel-to-bus bank 107a has lower lyophilicity than pixel-to-pixel bank 107b on its surface. More specifically, anisole contact angle of pixel-to-bus bank 107a at the upper surface is preferably 40° to 55°, whereas anisole contact angle of pixel-to-pixel bank 107b at the upper surface is preferably 30° to less than 40°.

By making the lyophilicity of pixel-to-bus bank 107a lower than the lyophilicity of pixel-to-pixel bank 107b in this way, it is possible to level the edge height of an organic layer (hole transport layer and organic light-emitting layer) and thus to provide an organic layer with uniform thickness.

Counter electrode 117 is made of ITO, for example. Sealing film 119 is, for example, a film made of silicon nitride with a thickness of 20 to 500 nm.

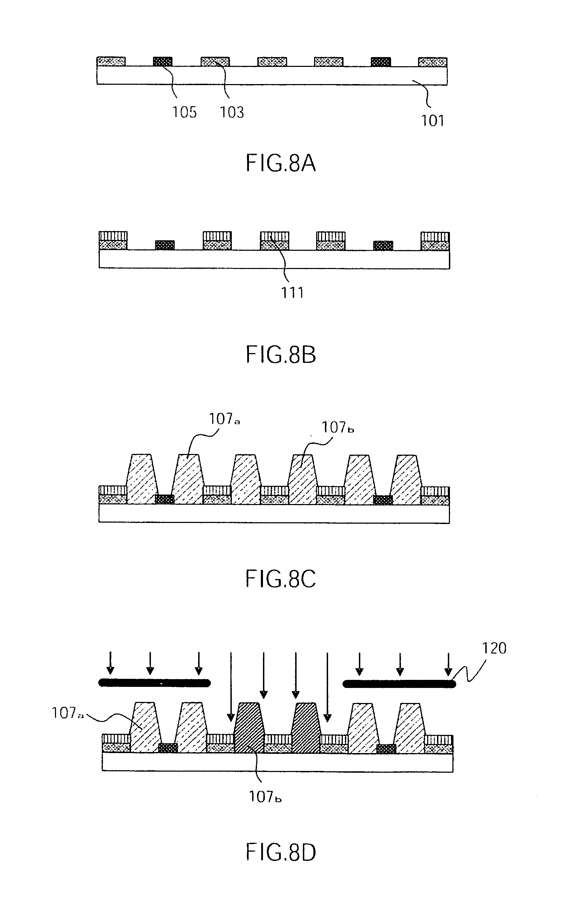

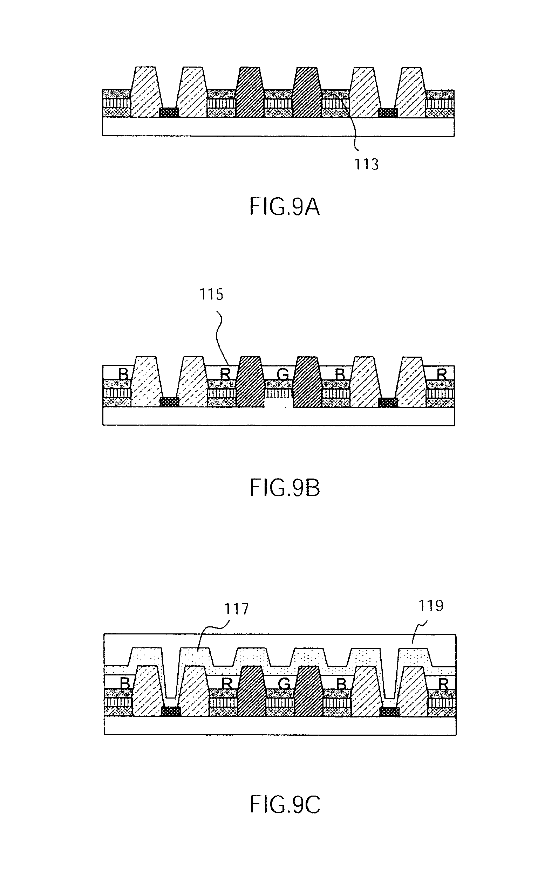

Next, a manufacturing method of the organic EL display panel of this embodiment will be described. Figs.8A to 8D and 9A to 9C illustrate one example of a manufacturing method of the organic EL display panel of Embodiment 1.

As illustrated in Figs.8A to 8D and 9A to 9C, a manufacturing method of organic EL display panel 100 includes: 1) a first step of providing substrate 101 having thereon reflective pixel electrode 103 and bus electrode 105 (Fig.8A); 2) a second step of forming hole injection layer 111 on reflective pixel electrode (Fig.8B); 3) a third step of forming bank 107 on substrate 101 (Fig.8C); 4) a fourth step of irradiating only pixel-to-pixel bank 107b with UV rays (Fig.8D); 5) a fifth step of forming hole transport layer 113 on hole injection layer 111 in regions defined by bank 107 (Fig.9A); 6) a sixth step of forming organic light-emitting layer 115 on hole transport layer 113 (Fig.9B); and 7) a seventh step of forming counter electrode 117 and sealing film 119 (Fig.9C).

1) In the first step, substrate 101 on which reflective pixel electrode 103 and bus electrode 105 are disposed is provided. Reflective pixel electrode 103 and bus electrode 105 may be patterned by etching a conductive film formed on substrate 101 by sputtering or the like.

2) In the second step, hole injection layer 111 is formed on reflective pixel electrode 103 by sputtering or the like.

3) In the third step, bank 107 is formed by the photolithographic method.

4) In the fourth step, only pixel-to-pixel bank 107b is irradiated with ultraviolet rays via mask 120.

5) In the fifth step, hole transport layer 113 is formed on hole injection layer 111. Hole transport layer 113 is formed by applying a material solution of hole transport layer 113 in a region defined by bank 107 by inkjet printing or the like.

6) In the sixth step, organic light-emitting layer 115 is formed on hole transport layer 113. Organic light-emitting layer 115 is formed by applying a material solution of organic light-emitting layer 115 in a region defined by bank 107 by inkjet printing or the like.

The conventional organic EL display panel has a problem that the edge height of an organic layer (hole transport layer and organic light-emitting layer) formed in a region defined by the pixel-to-bus bank and pixel-to-pixel bank becomes large on the pixel-to-bus bank side (see Fig.2E). In this embodiment, however, it is possible to lower the edge height of the organic layer on the pixel-to-bus bank side, by making the lyophilicity of pixel-to-bus bank 107a lower than the lyophilicity of pixel-to-pixel bank 107b. It is thus possible to level organic layer thickness.

7) In the seventh step, counter electrode 117 and sealing film 119 are formed. Counter electrode 117 is formed by vacuum deposition, for example, and sealing film 119 is formed by chemical vapor deposition (CVD), for example.

According to Embodiment 1 of the present invention, by making the lyophilicity of the pixel-to-bus bank lower than the lyophilicity of the pixel-to-pixel bank, it is thus possible to level the edge height of an organic layer (hole transport layer and organic light-emitting layer) and thus to provide an organic layer with uniform thickness. Moreover, UV irradiation provides a secondary effect of removing bank residues remained on the hole injection layer. By removing bank residues remained on the pixel electrode, it is possible to improve luminous characteristics of the organic EL display panel.

### (Embodiment 2)

Embodiment 1 described an embodiment in which the pixel-to-bus bank has lower lyophilicity than the pixel-to-pixel bank. Embodiment 2 describes an embodiment in which the pixel-to-bus bank has a smaller taper angle than the pixel-to-pixel bank.

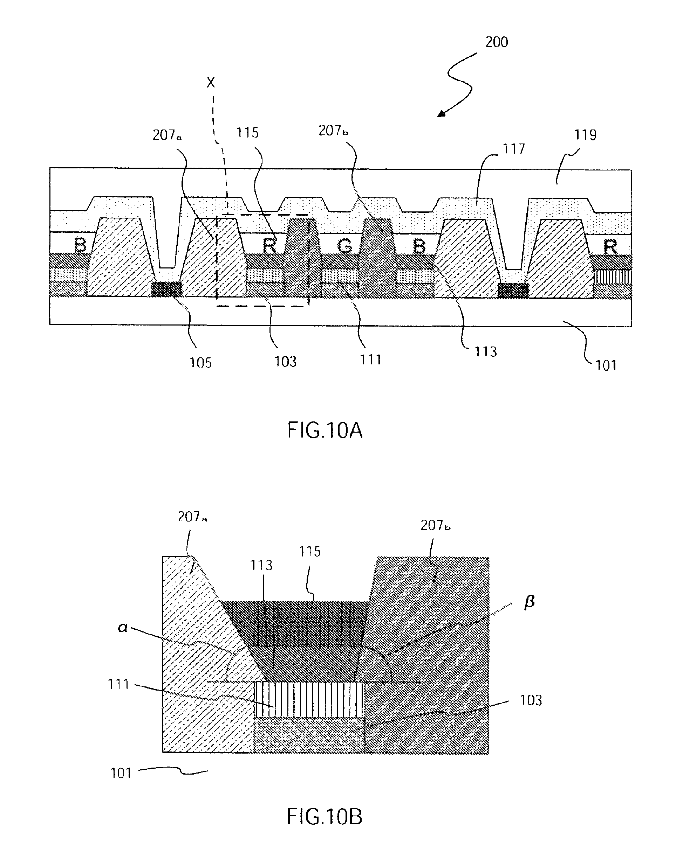

Fig.10A is a partial enlarged view of a section of organic EL display panel 200 of Embodiment 2. The organic EL display panel of Embodiment 2 is identical to that of organic EL display panel 100 of Embodiment 1 except for the shape of the pixel-to-bus bank. The same components as those of organic EL display panel 100 are given the same references and descriptions thereof are not given.

As illustrated in Fig.10A, organic EL display panel 200 includes pixel-to-bus bank 207a and pixel-to-pixel bank 207b. Fig.10B is an enlarged view of the region surrounded by square X in Fig.10A. As illustrated in Fig.10B, taper angle α of pixel-to-bus bank 207a is smaller than taper angle β of pixel-to-pixel bank 207b. Taper angle α of pixel-to-bus bank 207a is preferably 20° to 30°, and taper angle β of pixel-to-pixel bank 207b is preferably greater than 30° to 60°.

By making the taper angle of pixel-to-bus bank 207a smaller than the taper angle of pixel-to-pixel bank 207b in this way, it is possible to level the edge height of an organic layer (hole transport layer and organic light-emitting layer) and thus to provide an organic layer with uniform thickness.

Next, a manufacturing method of organic EL display panel 200 of this embodiment will be described. The manufacturing method of organic EL display panel 200 is the same as that for organic EL display panel 100 except for the manufacturing method of banks. Thus, the following exclusively describes the manufacturing method of banks in the manufacturing method of organic EL display panel 200.

Figs.11A to 11E are schematic illustrations of one example of a manufacturing method of organic EL display panel 200 of Embodiment 2. As illustrated in Figs. 11A to 11E, a manufacturing method of forming bank 207 of organic EL display panel 200 includes: 1) a first step of forming negative photosensitive resin film 106 on substrate 101 (Fig.11A); 2) a second step of exposing and developing photosensitive resin film 106 to pattern bank 207 (Figs. 11B and 11C); 3) a third step of re-exposing pixel-to-pixel bank 207b (Fig.11D); and 4) a forth step of baking bank 207 so as to be secured to substrate 101 (Fig. 11E).

1) In the first step, negative photosensitive resin film 106 is formed on substrate 101 on which bus electrode 105, pixel electrode 103, and hole injection layer 1111 are disposed. Formation of photosensitive resin film 106 on substrate 101 may be accomplished by applying a photosensitive resin composition over the substrate by spin coating, die coating, slit coating or the like and baking the formed film.

2) In the second step, photosensitive resin film 106 is exposed and developed to pattern bank 207. By patterning bank 207, hole injection layer 111 and bus electrode 105 are exposed.

3) In the third step, pixel-to-pixel bank 207b is re-exposed. This step is performed between the second step and forth step. Exposure dose for re-exposure is, for example, 300 mJ/cm². Re-exposure of pixel-to-pixel bank 207b results in elevation of glass transition temperature and elastic modulus.

4) In the forth step, patterned bank 207 is baked. Because pixel-to-pixel bank 207b has a high glass transition temperature and a high elastic modulus as described above, the elastic modulus does not drop due to heat during the baking process, whereby, pixel-to-pixel bank 207b spreads toward the bottom to a lesser extent and thus has a large taper angle. On the other hand, since the glass transition temperature and elastic modulus of pixel-to-bus bank 207a, which is not re-exposed, remain low, the elastic modulus drops due to heat during the baking process. Thus, pixel-to-bus bank 207a spreads toward the bottom and thus has a small taper angle. In this way it is possible to make the taper angle of the pixel-to-bus bank smaller than the taper angle of the pixel-to-pixel bank.

The conventional organic EL display panel has a problem that the edge height of an organic layer (hole transport layer and organic light-emitting layer) formed in a region defined by the pixel-to-bus bank and pixel-to-pixel bank becomes large on the pixel-to-bus bank side (see Fig.2E). In the present invention, by making the taper angle of pixel-to-bus bank 207a smaller than the taper angle of pixel-to-pixel bank 207b as described above, it is possible to lower the edge height of the organic layer on the pixel-to-bus bank 207a side. Thus, it is possible to level organic layer thickness.

According to Embodiment 2, by making the taper angle of the pixel-to-bus bank smaller than the taper angle of the pixel-to-pixel bank in this way, it is possible to level the edge height of an organic layer (hole transport layer and organic light-emitting layer) and thus to provide an organic layer with uniform thickness.

### Industrial Applicability

The present invention enables to suppress organic layer thickness variation even when bus electrodes are provided, thus making it possible to provide an organic EL display panel that offers excellent luminous characteristics.

### Reference Signs List

100, 200 Organic EL display panel
101 Substrate
103 Pixel Electrode
105 Bus Electrode
106 Photosensitive Resin Film
107 Bank
107a, 207a Pixel-to-bus bank
107b, 207b Pixel-to-pixel bank
109 Organic Layer
111 Hole Injection Layer
113Hole Transport Layer
115Organic Light-emitting Layer
117 Counter Electrode
119 Sealing Film
120 Mask
130 Material Solution
131Liquid Drop Edge

## Claims

1. An organic EL display panel comprising:
a substrate (101);
at least two pixel electrodes (103) disposed on the substrate (101);
a bus electrode (105) disposed on the substrate (101), the bus electrode (105) disposed adjacent to at least one of the pixel electrodes (103);
an organic layer (109) disposed over the pixel electrodes (103);
at least two banks (107) disposed on the substrate (101), the banks (107) defining a region in which the organic layer (109) is disposed; and
a counter electrode (117) disposed over the organic layer (109), the counter electrode (117) connected to the bus electrode (105),
**characterized in that**
the at least two banks (107) each contain fluorine resin,
the at least two banks (107) including a bank (107) disposed between the bus electrode (105) and the adjacent pixel electrode (103), and a bank (107) disposed between the pixel electrodes (103), and
a lyophilicity of the bank (107) disposed between the bus electrode (105) and the adjacent pixel electrode (103) is lower than a lyophilicity of the bank (107) disposed between the pixel electrodes (103).

2. The organic EL display panel according to claim 1, wherein an anisole contact angle at an upper surface of the bank (107) disposed between the pixel electrodes (103) is 30° to 40', and
an anisole contact angle at an upper surface of the bank (107) disposed between the bus electrode (105) and the adjacent pixel electrode (103) is 40° to 55°.

3. The organic EL display panel according to claim 1, further comprising a hole injection layer (111) disposed over the pixel electrode (103),
wherein the organic layer (109) includes a hole transport layer (113) disposed on the hole injection layer (111), and an organic light-emitting layer(115) disposed on the hole transport layer (113).

4. An organic EL display panel comprising:
a substrate (101);
at least two pixel electrodes (103) disposed on the substrate (101);
a bus electrode (105) disposed on the substrate (101), the bus electrode (105) disposed adjacent to at least one of the pixel electrodes (103);
an organic layer (109) disposed over the pixel electrodes (103);
at least two banks (107) disposed on the substrate (101), the banks (107) defining a region in which the organic layer (109) is disposed; and
a counter electrode (117) disposed over the organic layer (109), the counter electrode (117) connected to the bus electrode (105),
**characterized in that**
the at least two banks (107) each contain fluorine resin,
the at least two banks (107) including a bank (107) disposed between the bus electrode (105) and the adjacent pixel electrode (103), and a bank (107) disposed between the pixel electrodes (103); and
a taper angle of the bank (107) disposed between the bus electrode (105) and the adjacent pixel electrode (103) is smaller than a taper angle of the bank (107) disposed between the pixel electrodes (103).

5. The organic EL display panel according to claim 4, wherein the taper angle of the bank (107) disposed between the bus electrode (105) and the adjacent pixel electrode (103) is 20° to 30°, and
the taper angle of the bank (107) disposed between the pixel electrodes (103) is 30° to 60°.

6. The organic EL display panel according to claim 4, further comprising a hole injection layer (111) disposed over the pixel electrode (103),
wherein the organic layer (109) includes a hole transport layer (113) disposed on the hole injection layer (111), and an organic light-emitting layer (115) disposed on the hole transport layer (113).

7. A manufacturing method of an organic EL display panel as recited in claim 1, comprising:
providing a substrate (101) having thereon at least two pixel electrodes (103) and a bus electrode (105) disposed adjacent to at least one of the pixel electrodes (103);
forming a photosensitive resin film (106) on the substrate (101);
exposing and developing the photosensitive resin film (106) to pattern at least two banks (107), the at least two banks (107) including a bank (107) disposed between the bus electrode (105) and the adjacent pixel electrode (103), and a bank (107) disposed between the pixel electrodes (103);
baking the at least two banks (107) to secure the at least two banks (107) to the substrate (101);
irradiating only the bank (107) disposed between the pixel electrodes (103) with active rays; and
applying an ink containing a material of an organic layer (109) in a region which is positioned over the pixel electrodes (103) and defined by the at least two banks(107), to form an organic layer (109).

8. A manufacturing method of an organic EL display panel as recited in claim 4, comprising:
providing a substrate (101) having thereon at least two pixel electrodes (103) and a bus electrode (105) disposed adjacent to at least one of the pixel electrodes (103);
forming a negative photosensitive resin film (106) on the substrate (101);
exposing and developing the photosensitive resin film (106) to pattern at least two banks, the at least two banks (107) including a bank (107) disposed between the bus electrode (105) and the adjacent pixel electrode (103), and a bank (107) disposed between the pixel electrodes (103);
re-exposing only the bank (107) disposed between the pixel electrodes (103);
baking the at least two banks (107) to secure the at least two banks (107) to the substrate (101); and
applying an ink containing a material of an organic layer (109) in a region which is positioned over the pixel electrodes (103) and defined by the at least two banks (107), to form an organic layer (109).

## Patentansprüche

1. Organisches EL-Display, das umfasst:
ein Substrat (101);
wenigstens zwei Pixel-Elektroden (103), die auf dem Substrat (101) angeordnet sind;
eine Bus-Elektrode (105), die auf dem Substrat (101) angeordnet ist, wobei die Bus-Elektrode (105) an wenigstens eine der Pixel-Elektroden (103) angrenzend angeordnet ist;
eine organische Schicht (109), die über den Pixel-Elektroden (103) angeordnet ist;
wenigstens zwei Bänke (107), die auf dem Substrat (101) angeordnet sind, wobei die Bänke (107) einen Bereich bilden, in dem die organische Schicht (109) angeordnet ist; und
eine Gegenelektrode (117), die über der organischen Schicht (109) angeordnet ist, wobei die Gegenelektrode (117) mit der Bus-Elektrode (105) verbunden ist,
**dadurch gekennzeichnet, dass**
die wenigstens zwei Bänke (107) jeweils Fluor-Harz enthalten,
die wenigstens zwei Bänke (107) eine Bank (107), die zwischen der Bus-Elektrode (105) und der angrenzenden Pixel-Elektrode (103) angeordnet ist, sowie eine Bank (107) enthalten, die zwischen den Pixel-Elektroden (103) angeordnet ist, und
ein lyophiler Charakter der Bank (107), die zwischen der Bus-Elektrode (105) und der angrenzenden Pixel-Elektrode (103) angeordnet ist, niedriger ist als ein lyophiler Charakter der Bank (107), die zwischen den Pixel-Elektroden (103) angeordnet ist.

2. Organisches EL-Display nach Anspruch 1, wobei ein Anisol-Kontaktwinkel an einer oberen Fläche der zwischen den Pixel-Elektroden (103) angeordneten Bank (107) 30° bis 40° beträgt, und
ein Anisol-Kontaktwinkel an einer oberen Fläche der zwischen der Bus-Elektrode (105) und der angrenzenden Pixel-Elektrode (103) angeordneten Bank (107) 40° bis 55° beträgt.

3. Organisches EL-Display nach Anspruch 1, das des Weiteren eine Lochinjektions-Schicht (111) umfasst, die über der Pixel-Elektrode (103) angeordnet ist,
wobei die organische Schicht (109) eine Lochleitungs-Schicht (113), die auf der Lochinjektions-Schicht (111) angeordnet ist, und eine organische Lichtemissions-Schicht (115) enthält, die auf der Lochleitungs-Schicht (113) angeordnet ist.

4. Organisches EL-Display, das umfasst:
ein Substrat (101);
wenigstens zwei Pixel-Elektroden (103), die auf dem Substrat (101) angeordnet sind;
eine Bus-Elektrode (105), die auf dem Substrat (101) angeordnet ist, wobei die Bus-Elektrode (105) an wenigstens eine der Pixel-Elektroden (103) angrenzend angeordnet ist;
eine organische Schicht (109), die über den Pixel-Elektroden (103) angeordnet ist;
wenigstens zwei Bänke (107), die auf dem Substrat (101) angeordnet sind, wobei die Bänke (107) einen Bereich bilden, in dem die organische Schicht (109) angeordnet ist; und
eine Gegenelektrode (117), die über der organischen Schicht (109) angeordnet ist, wobei die Gegenelektrode (117) mit der Bus-Elektrode (105) verbunden ist,
**dadurch gekennzeichnet, dass**
die wenigstens zwei Bänke (107) jeweils Fluor-Harz enthalten,
die wenigstens zwei Bänke (107) eine Bank (107), die zwischen der Bus-Elektrode (105) und der angrenzenden Pixel-Elektrode (103) angeordnet ist, sowie eine Bank (107) enthalten, die zwischen den Pixel-Elektroden (103) angeordnet ist, und
ein Kegelwinkel der zwischen der Bus-Elektrode (105) und der angrenzenden Pixel-Elektrode (103) angeordneten Bank (107) kleiner ist als ein Kegelwinkel der zwischen den Pixel-Elektroden (103) angeordneten Bank (107).

5. Organisches EL-Display nach Anspruch 4, wobei der Kegelwinkel der zwischen der Bus-Elektrode (105) und der angrenzenden Pixel-Elektrode (103) angeordneten Bank (107) zwischen 20° und 30° beträgt, und
der Kegelwinkel der zwischen den Pixel-Elektroden (103) angeordneten Bank (107) 30° bis 60° beträgt.

6. Organisches EL-Display nach Anspruch 4, das des Weiteren eine Lochinjektions-Schicht (111) umfasst, die über der Pixel-Elektrode (103) angeordnet ist,
wobei die organische Schicht (109) eine Lochleitungs-Schicht (113), die auf der Lochinjektions-Schicht (111) angeordnet ist, und eine organische Lichtemissions-Schicht (115) enthält, die auf der Lochleitungs-Schicht (113) angeordnet ist.

7. Verfahren zum Herstellen eines organischen EL-Displays nach Anspruch 1, das umfasst:
Bereitstellen eines Substrats (101), das wenigstens zwei Pixel-Elektroden (103) und eine an wenigstens eine der Pixel-Elektroden (103) angrenzend angeordnete Bus-Elektrode (105) darauf aufweist;
Ausbilden eines Films (106) aus fotoempfindlichem Harz auf dem Substrat (101);
Belichten und Entwickeln des Films (106) aus fotoempfindlichem Harz, um wenigstens zwei Bänke (107) zu strukturieren, wobei die wenigstens zwei Bänke (107) eine Bank (107), die zwischen der Bus-Elektrode (105) und der angrenzenden Pixel-Elektrode (103) angeordnet ist, sowie eine Bank (107) enthalten, die zwischen den Pixel-Elektroden (103) angeordnet ist;
Brennen der wenigstens zwei Bänke (107), um die wenigstens zwei Bänke (107) an dem Substrat (101) zu befestigen;
Bestrahlen nur der zwischen den Pixel-Elektroden (103) angeordneten Bank (107) mit aktiven Strahlen; und
Aufbringen einer Tinte, die ein Material einer organischen Schicht (109) enthält, in einem Bereich, der sich über den Pixel-Elektroden (103) befindet und durch die wenigstens zwei Bänke (107) abgegrenzt wird, um eine organische Schicht (109) auszubilden.

8. Verfahren zum Herstellen eines organischen EL-Displays nach Anspruch 4, das umfasst:
Bereitstellen eines Substrats (101), das wenigstens zwei Pixel-Elektroden (103) und eine an wenigstens eine der Pixel-Elektroden (103) angrenzend angeordnete Bus-Elektrode (105) darauf aufweist;
Ausbilden eines Films (106) aus negativem fotoempfindlichem Harz auf dem Substrat (101);
Belichten und Entwickeln des Films (106) aus fotoempfindlichem Harz, um wenigstens zwei Bänke (107) zu strukturieren, wobei die wenigstens zwei Bänke (107) eine Bank (107), die zwischen der Bus-Elektrode (105) und der angrenzenden Pixel-Elektrode (103) angeordnet ist, sowie eine Bank (107), die zwischen den Pixel-Elektroden (103) angeordnet ist, enthalten;
erneutes Belichten nur der zwischen den Pixel-Elektroden (103) angeordneten Bank (107);
Brennen der wenigstens zwei Bänke (107), um die wenigstens zwei Bänke (107) an dem Substrat (101) zu befestigen; und
Aufbringen einer Tinte, die ein Material einer organischen Schicht (109) enthält, in einem Bereich, der sich über den Pixel-Elektroden (103) befindet und durch die wenigstens zwei Bänke (107) gebildet wird, um eine organische Schicht (109) auszubilden.

## Revendications

1. Panneau d'affichage électroluminescent organique comprenant :
un substrat (101),
au moins deux électrodes de pixel (103) placées sur le substrat (101),
une électrode de bus (105) placée sur le substrat (101), l'électrode de bus (105) étant disposée de manière adjacente à au moins l'une des électrodes de pixel (103),
une couche organique (109) placée par dessus les électrodes de pixel (103),
au moins deux rangées (107) placées sur le substrat (101), les rangées (107) définissant une zone dans laquelle est placée la couche organique (109), et
une contre électrode (117) placée par-dessus la couche organique (109), la contre électrode (117) étant reliée à l'électrode de bus (105),
**caractérisé en ce que**
les au moins deux rangées (107) contiennent chacune une résine de fluor,
les au moins deux rangées (107) incluant une rangée (107) disposée entre l'électrode de bus (105) et l'électrode de pixel adjacente (103), ainsi qu'une rangée (107) disposée entre les électrodes de pixel (103), et
le caractère lyophile de la rangée (107) disposée entre l'électrode de bus (105) et l'électrode de pixel adjacente (103) est inférieur au caractère lyophile de la rangée (107) disposée entre les électrodes de pixel (103).

2. Panneau d'affichage électroluminescent organique selon la revendication 1, dans lequel un angle de contact d'anisole à la surface supérieure de la rangée (107) disposée entre les électrodes de pixel (103) est de 30 ° à 40 °, et
un angle de contact d'anisole à la surface supérieure de la rangée (107) disposée entre l'électrode de bus (105) et l'électrode de pixel adjacente (103) est de 40 ° à 55 °.

3. Panneau d'affichage électroluminescent organique selon la revendication 1, comprenant en outre une couche d'injection de trous (111) disposée par-dessus l'électrode de pixel (103),
dans lequel la couche organique (109) inclut une couche de transport de trous (113) disposée sur la couche d'injection de trous (111), et une couche d'émission de lumière organique (115) disposée sur la couche de transport de trous (113).

4. Panneau d'affichage électroluminescent organique comprenant :
un substrat (101),
au moins deux électrodes de pixel (103) placées sur le substrat (101),
une électrode de bus (105) placée sur le substrat (101), l'électrode de bus (105) étant disposée de manière adjacente à au moins l'une des électrodes de pixel (103),
une couche organique (109) placée sur les électrodes de pixel (103),
au moins deux rangées (107) placées sur le substrat (101), les rangées (107) définissant une zone dans laquelle est placée la couche organique (109), et
une contre électrode (117) placée sur la couche organique (109), la contre électrode (117) étant reliée à l'électrode de bus (105),
**caractérisé en ce que**
les au moins deux rangées (107) contiennent chacune une résine de fluor,
les au moins deux rangées (107) incluant une rangée (107) disposée entre l'électrode de bus (105) et l'électrode de pixel adjacente (103), ainsi qu'une rangée (107) disposée entre les électrodes de pixel (103), et
un angle de chanfrein de la rangée (107) disposé entre l'électrode de bus (105) et l'électrode de pixel adjacente (103) est plus petit qu'un angle de chanfrein de la rangée (107) disposée entre les électrodes de pixel (103).

5. Panneau d'affichage électroluminescent organique selon la revendication 4, dans lequel l'angle de chanfrein de la rangée (107) placée entre l'électrode de bus (105) et l'électrode de pixel adjacente (103) est de 20 ° à 30 °, et
l'angle de chanfrein de la rangée (107) placée entre les électrodes de pixel (103) est de 30 ° à 60 °.

6. Panneau d'affichage électroluminescent organique selon la revendication 4, comprenant en outre une couche d'injection de trous (111) placée par-dessus l'électrode de pixel (103),
dans lequel la couche organique (109) inclut une couche de transport de trous (113) disposée sur la couche d'injection de trous (111), et une couche organique d'émission de lumière (115) disposée sur la couche de transport de trous (113).

7. Procédé de fabrication d'un panneau d'affichage électroluminescent organique selon la revendication 1 comprenant :
la fourniture d'un substrat (101) comportant sur lui-même au moins deux électrodes de pixel (103) et une électrode de bus (105) placée de manière adjacente à au moins l'une des électrodes de pixel (103),
la formation d'un film de résine photosensible (106) sur le substrat (101),
l'exposition et le développement du film de résine photosensible (106) afin de structurer au moins deux rangées (107), les au moins deux rangées (107) incluant une rangée (107) disposée entre l'électrode de bus (105) et l'électrode de pixel adjacente (103), ainsi qu'une rangée (107) disposée entre les électrodes de pixel (103),
la cuisson des au moins deux rangées (107) afin de protéger les au moins deux rangées (107) sur le substrat (101),
l'irradiation de seulement la rangée (107) disposée entre les électrodes de pixel (103) grâce à des rayons actifs, et
l'application d'une encre contenant un matériau de couche organique (109) dans une zone qui est positionnée par-dessus les électrodes de pixel (103) et définie par les au moins deux rangées (107), dans le but de former une couche organique (109).

8. Procédé de fabrication d'un panneau d'affichage électroluminescent organique selon la revendication 4 comprenant :
la fourniture d'un substrat (101) comportant sur lui-même au moins deux électrodes de pixel (103) et une électrode de bus (105) disposée de manière adjacente à au moins l'une des électrodes de pixel (103),
la formation d'un film de résine photosensible négatif (106) sur le substrat (101),
l'exposition et le développement du film de résine photosensible (106) afin de structurer au moins deux rangées (107), les au moins deux rangées (107) incluant une rangée (107) disposée entre l'électrode de bus (105) et l'électrode de pixel adjacente (103), ainsi qu'une rangée (107) disposée entre les électrodes de pixel (103),
une nouvelle exposition de seulement la rangée (107) disposée entre les électrodes de pixel (103),
la cuisson des au moins deux rangées (107) afin de protéger les au moins deux rangées (107) sur le substrat (101),
l'application d'une encre contenant un matériau de couche organique (109) dans une zone qui est positionnée par-dessus les électrodes de pixel (103) et définie par les au moins deux rangées (107), dans le but de former une couche organique (109).
